# EUROPEAN PATENT APPLICATION

(11) **EP 4 576 226 A1**
(43) Date of publication of application: **25.06.2025**
(21) Application number: 23934919.4
(22) Date of filing: 11.10.2023
(51) Int. Cl.: H01L 31/0236

(54) **BACK CONTACT SOLAR CELL AND METHOD FOR PREPARING SAME**

(30) Priority: 28.04.2023 CN 202310501272
(71) Applicant: CHINT New Energy Technology Co., Ltd., Haining, Zhejiang 314400 (CN)
(72) Inventor: HE, Sheng, Jiaxing, Zhejiang 314400 (CN); FENG, Mingzhang, Jiaxing, Zhejiang 314400 (CN); HSU, Wei-chih, Jiaxing, Zhejiang 314400 (CN); HUANG, Haiyan, Jiaxing, Zhejiang 314400 (CN)
(74) Representative: PGA S.p.A., Milano, Succursale di Lugano
(86) International application number: PCT/CN2023/123977
(87) International publication number: WO 2024/221750

(57) **Abstract**

Disclosed is a back contact solar cell. A back surface field region is arranged as a columnar hole structure, such that the thickness of a silicon substrate can be fully utilized to form a bottom region and a column wall back surface field region, the back surface field collecting area is increased without occupying additional back surface area, and the area of a back surface emitting region is maximized. For a solar cell, within a certain proportion range, the larger the area of an emitter is, the better the capture and transmission performance for minority carriers is, and the higher the efficiency of the cell is; meanwhile, the back surface field region is deeply arranged into a silicon wafer, so that majority carriers can be collected in the silicon wafer, the transmission and collection distance is shortened, and the collection effect is enhanced. Thus, the structure can enhance the collecting of the minority carriers and the majority carriers, and the efficiency of the cell is overall improved.

## Description

This application claims priority to Chinese Patent Application No. 202310501272.9, titled "BACK CONTACT SOLAR CELL AND METHOD FOR PREPARING SAME", filed on April 28, 2023 with the China National Intellectual Property Administration, which is incorporated herein by reference in its entirety.

### FIELD

The present disclosure relates to the field of solar cell technology and in particular to a back contact solar cell and a method for manufacturing same.

### BACKGROUND

At present, with the gradual depletion of fossil energy, solar cells, as a new energy alternative, are increasingly used. The solar cells are devices that convert solar light energy into electrical energy. They generate carriers through a photovoltaic principle, and then use electrodes to lead out the carriers, so as to facilitate utilizing electrical energy effectively.

In back contact cells, p-type back contact solar cells are called IBC cells. IBC stands for interdigitated back-contacted. A biggest feature of the IBC cells is that the emitter and metal contact are both on the back surface of the cells, and there is no metal electrode blocking effect on the front surface. Thus it has a higher short-circuit current Jsc. At the same time, the back surface can allow wider metal gate lines to reduce the series resistance Rs and thus increase the filling factor FF. And this type of cell with no obstruction on the front surface not only has high conversion efficiency, but also looks well-designed. Moreover, components with full back electrodes are easier to assemble. IBC cells are one of the current technical directions for achieving high-efficiency crystalline silicon cells.

At present, conventional p-type interdigitated back-contacted solar cells have a p-type base or a diffused n-type emitter on their backside region. However, it is a challenge to choose a dielectric layer that can passivate both regions equally well, and most dielectric layers have surface charges that can cause shunting, resulting in extremely poor cell effects. For example, well-known passivation dielectric layers are aluminum oxide (Al₂O₃) with negative surface charges and hydrogenated amorphous silicon nitride (α-SiNx:H) with positive surface charges. In addition, carriers of the interdigitated back-contacted cell need to be diffused from the front surface to the back surface field of the back surface to be collected, resulting in poor collecting efficiency, which in turn leads to reduced cell efficiency.

Chinese patent with publication number CN111108609A discloses an interdigitated back-contacted solar cell with p-type conductivity, the interdigitated back-contacted solar cell with p-type conductivity has a front surface for receiving radiation, and a rear surface. The rear surface has a tunneling oxide layer and a doped polysilicon layer of n-type conductivity. The tunneling oxide layer and the doped polysilicon layer of n-type conductivity form a patterned layer stack, and the patterned layer stack has gaps, wherein an Al-Si alloyed contact is arranged within each of the gaps and is in electrical contact with a base layer of the substrate, and one or more Ag contacts or transition metal contacts are arranged on the patterned doped polysilicon layer and are in electrical contact with the patterned doped polysilicon layer. Although this structure can reduce shunting and improve battery effect, the structure is complex and the preparation method is more difficult.

### SUMMARY

In view of the above, a technical problem to be solved by the present disclosure is to provide a back contact solar cell and a preparation method thereof. The back contact solar cell can enhance the carrier collection effect and improve the battery efficiency.

The present disclosure provides a back contact solar cell, comprising:
a silicon substrate,
where a back surface of the silicon substrate is provided with a columnar hole and a non-columnar hole region;
a doped back surface field layer provided in the columnar hole;
a first electrode provided on the back surface of the silicon substrate, wherein the first electrode is in electrical contact with the doped back surface field layer;
a doped emitter layer provided in the non-columnar hole region, wherein the doped emitter layer comprises a doped polysilicon layer; and
a second electrode provided on the back surface of the silicon substrate, wherein the second electrode is in electrical contact with the doped polysilicon layer;
where the first electrode and the second electrode have opposite polarities and are insulated from each other.

In one embodiment, the doped back surface field layer is provided on a side wall or a bottom surface of the columnar hole .

In one embodiment, a diameter of the columnar hole is 50-300 µm, the number of the columnar hole is plural, an interval between adjacent columnar holes is 500-3000 µm; a depth of the columnar hole is 30%-80% of a thickness of the silicon substrate.

In one embodiment, the number of the columnar hole is plural, the first electrode is provided in each columnar hole, the plural first electrodes are connected through a first conductive paste line; the number of the second electrode is plural, the plural second electrodes are connected through a second conductive paste line; the first conductive paste line is not in contact with the second conductive paste line.

In one embodiment, the first conductive paste line connects the first electrode in a square spiral shape, the second conductive paste line connects the second electrode in a square spiral shape.

In one embodiment, the doped emitter layer further comprises a tunneling oxide layer, and the tunneling oxide layer is provided between the silicon substrate and the doped polysilicon layer in the non-columnar hole region.

In one embodiment, a thickness of the tunneling oxide layer is 0.1nm to 5nm, a thickness of the doped polysilicon layer is 30nm to 300nm, a diameter of the first electrode is 200µm to 100µm, a diameter of the second electrode is 10µm to 30µm.

In one embodiment, the silicon substrate is a P-type silicon substrate, the doped back surface field layer is a back surface field layer doped with group III elements, the doped polysilicon layer is a polysilicon layer doped with group V elements.

In one embodiment, the silicon substrate is an N-type silicon substrate; the doped back surface field layer is a back surface field layer doped with group V elements, the doped polysilicon layer is a polysilicon layer doped with group III elements.

The present disclosure further provides a method for manufacturing the above-mentioned back contact solar cell, comprising the following steps:
S1) depositing an intrinsic amorphous silicon layer on a back surface of a silicon substrate;
S2) performing a first doping treatment on the silicon substrate on which the intrinsic amorphous silicon layer is deposited to form a doped polysilicon layer;
S3) printing an acidic corrosive material on the back surface of the silicon substrate on which the doped polysilicon layer is formed, and performing a polishing treatment to form a columnar hole and/or a conical hole;
S4) performing a second doping treatment on the silicon substrate on which the columnar hole and/or conical hole are formed to form a doped back surface field layer;
S5) performing pickling on the silicon substrate on which the doped back surface field layer is formed;
S6) preparing a first electrode in electrical contact with the doped back surface field layer and preparing a second electrode in electrical contact with the doped polysilicon layer respectively on the back surface of the silicon substrate after pickling to obtain the back contact solar cell, where the first electrode and the second electrode have opposite polarities and are insulated from each other.

The present disclosure provides a back contact solar cell, comprising: a silicon substrate, where a back surface of the silicon substrate is provided with a columnar hole and a non-columnar hole region; a doped back surface field layer provided in the columnar hole; a first electrode provided on the back surface of the silicon substrate, wherein the first electrode is in electrical contact with the doped back surface field layer; a doped emitter layer provided in the non-columnar hole region, wherein the doped emitter layer comprises a doped polysilicon layer; and a second electrode provided on the back surface of the silicon substrate, wherein the second electrode is in electrical contact with the doped polysilicon layer. Compared with the conventional technology, in the present disclosure, the columnar hole structure is utilized to arrange the back surface field region, such that the thickness of the silicon substrate can be fully utilized to form a back surface field region of the bottom region and the column wall, which increases the area of the back surface field collection region without occupying the back surface area, and also maximizes the back emission area. For a solar cell, within a certain range of proportions, the larger the proportion of the emitter area, the higher the capture and transmission performance of minority carriers. The efficiency of the cell is relatively high. The back surface field region deeply penetrates into the silicon wafer, so that majority carriers can be collected inside the silicon wafer, shortening the transmission and collection distance and enhancing the collecting effect. Therefore, the structure has an enhanced collecting effect on both minority carriers and majority carriers, thereby improving the efficiency of the cell as a whole.

### BRIEF DESCRIPTION OF THE DRAWINGS

FIG. 1 is a schematic structural diagram of a back contact solar cell according to an embodiment of the present disclosure.
FIG. 2 is a schematic diagram of a distribution of columnar holes of a back contact solar cell according to an embodiment of the present disclosure.
FIG. 3 is a schematic diagram of an electrode arrangement of a back contact solar cell according to an embodiment of the present disclosure.
FIG. 4 is a schematic structural diagram of a P-type silicon substrate after corrosion and polishing to form columnar holes according to an embodiment of the present disclosure.
FIG. 5 is a schematic structural diagram of a P-type silicon substrate after a second doping treatment to form a doped back surface field layer according to an embodiment of the present disclosure.
FIG. 6 is a schematic structural diagram of a silicon substrate after pickling according to an embodiment of the present disclosure.

### DETAILED DESCRIPTION

Technical solutions of embodiments of the present disclosure will be described clearly and completely below in combination with the embodiments of the present disclosure. Apparently, the described embodiments are only part, not all of the embodiments of the present disclosure. Based on the embodiments of the present disclosure, all other embodiments obtained by those skilled in the art without creative work belong to the scope of protection of the present disclosure.

The present disclosure provides a back contact solar cell, comprising:
a silicon substrate,
where a back surface of the silicon substrate is provided with a columnar hole and a non-columnar hole region;
a doped back surface field layer provided in the columnar hole;
a first electrode provided on the back surface of the silicon substrate, wherein the first electrode is in electrical contact with the doped back surface field layer;
a doped emitter layer provided in the non-columnar hole region, wherein the doped emitter layer comprises a doped polysilicon layer; and
a second electrode provided on the back surface of the silicon substrate, wherein the second electrode is in electrical contact with the doped polysilicon layer.

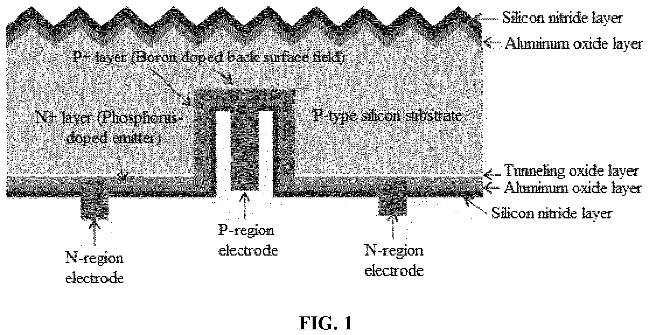

Reference is made to FIG. 1, which is a schematic structural diagram of the back contact solar cell according to an embodiment of the present disclosure.

The silicon substrate in the back contact solar cell according to the present disclosure may be any substrate familiar to those skilled in the art without any special restrictions. The silicon substrate may be a P-type silicon substrate or an N-type silicon substrate.

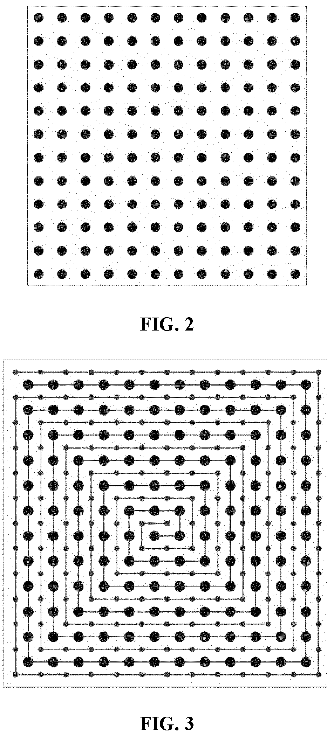

The back surface of the silicon substrate is provided with a columnar hole and/or a conical hole. The columnar hole may be cylindrical hole and/or prismatic hole, without any special restrictions. In one embodiment, the silicon substrate is preferably provided with a cylindrical hole. Reference is made to FIG. 2, which is a schematic diagram of a distribution of columnar holes of the back contact solar cell according to the present disclosure. A diameter of the columnar hole is preferably 50µm to 300µm, more preferably 80µm to 200µm, and more preferably 100µm to 150µm. The number of the columnar hole is preferably plural. An interval between adjacent columnar holes is preferably 500µm to 3000µm, more preferably 800µm to 2000µm, more preferably 800µm to 1500µm, and most preferably 1000µm. A depth of the columnar hole is preferably 30% to 80% of a thickness of the silicon substrate. In one embodiment, a bottom and/or a side wall of the columnar hole and/or conical hole are provided with a concave-convex texture structure. The number of the concave-convex texture structure can be one or plural, and there is no special restriction. The concave-convex texture structure is provided at the bottom and/or side wall of the columnar hole and/or conical hole to further expand the area of the back surface field region.

The columnar hole is provided with the doped back surface field layer. A thickness of the doped back surface field layer is preferably 0.3µm to 1µm. In one embodiment, the doped back surface field layer is preferably provided on the side wall and bottom surface of the columnar hole. The doping elements in the doped back surface field layer may be selected according to types of silicon substrate. When the silicon substrate is a P-type silicon substrate, the doped back surface field layer is a back surface field layer doped with group III elements, preferably a boron doped back surface field layer and/or a gallium doped back surface field layer, as a P+ back surface field region for selectively transmitting hole carriers. When the silicon substrate is an N-type silicon substrate, the doped back surface field layer is a back surface field layer doped with group V elements, preferably a phosphorus doped back surface field layer, as an N+ back surface field region for selectively transmitting electron carriers. In one embodiment, preferably, a back passivation layer is further provided on a surface of the doped back surface field layer. A thickness of the back passivation layer is preferably 62nm to 220nm. The back passivation layer may be a back passivation layer well known to those skilled in the art, and there is no special restriction. In one embodiment, the back passivation layer preferably comprises an aluminum oxide layer and a silicon nitride layer arranged in a stacked manner. A thickness of the aluminum oxide layer is preferably 2nm to 20nm. A thickness of the silicon nitride layer is preferably 60nm to 200nm.

The first electrode is provided on the back surface of the silicon substrate. That is, the first electrode is provided in the columnar hole. The first electrode is in electrical contact with the doped back surface field layer. A shape of the first electrode may be columnar or conical, and there is no special restriction. In one embodiment, it is preferably a cylinder. A diameter of the first electrode is preferably 200µm to 100µm. A height of the first electrode preferably extends to near a surface of a flat region of the silicon substrate. That is, the height of the first electrode is less than or equal to the depth of the columnar hole and/or conical hole. Furthermore, specifically, the height of the first electrode is less than or equal to the depth of the cylindrical hole. The first electrode is preferably an aluminum electrode. The first electrode plays a role of electrically contacting the doped back surface field layer.

In one embodiment, as the number of the columnar hole and/or conical hole is plural, each columnar hole and/or conical hole is provided with a first electrode, and the number of first electrodes is also plural. Therefore, preferably, the solar cell further comprises a first conductive gate line, which can also be called a first conductive paste line. The plural first electrodes are connected by the first conductive gate line or the first conductive paste line. More preferably, the first conductive gate line or the first conductive paste line is arranged on the surface of the back passivation layer to connect the plural first electrodes. Further preferably, the first conductive gate line or the first conductive paste line connects the first electrodes in a square spiral shape. A width of the first conductive gate line or the first conductive paste line is preferably 20µm to 300µm. The first conductive gate line or the first conductive paste line may be any type of gate line or paste line, which is well known to those skilled in the art, and there is no special restriction. In one embodiment, aluminum paste (sintered according to a method well known to those skilled in the art) is preferred.

The back surface of the silicon substrate is a non-columnar hole region except for columnar holes and/or conical holes. The doped emitter layer is provided on the surface of the silicon substrate of the non-columnar hole region. The doped emitter layer comprises the doped polysilicon layer. A thickness of the doped polysilicon layer is preferably 30nm to 300nm. The type of doping elements in the doped polysilicon layer is selected according to types of silicon substrate. When the silicon substrate is a P-type silicon substrate, the doped polysilicon layer is a polysilicon layer of group V elements, preferably a phosphorus doped polysilicon layer. When the silicon substrate is an N-type silicon substrate, the doped polysilicon layer is a polysilicon layer doped with group III elements, preferably a boron doped polysilicon layer and/or a gallium doped polysilicon layer. In one embodiment, preferably, the doped emitter layer further comprises a tunneling oxide layer. The tunneling oxide layer is provided between the silicon substrate and the doped polysilicon layer in the non-columnar hole region. The thickness of the tunneling oxide layer is preferably 0.1nm to 5nm, more preferably 0.5nm to 4nm, and more preferably 1nm to 3nm. The tunneling oxide layer may be a silicon oxide layer, a silicon nitride oxide layer or a silicon nitride layer. In one embodiment, preferably, the back passivation layer is provided on a surface of the doped emitter layer, and more preferably, the back passivation layer in the non-columnar hole region is integrated with the back passivation layer in the columnar holes and/or conical holes. That is, in one embodiment, the back passivation layer is provided on the back surface of the silicon substrate and covers the doped back surface field layer and the doped polysilicon layer. The back passivation layer is provided with an opening. The first electrode is in electrical contact with the doped back surface field layer through the opening. The second electrode is in electrical contact with the doped polysilicon layer through the opening. A thickness of the back passivation layer in the non-columnar hole region is preferably 62nm to 220nm. The back passivation layer is a back passivation layer well known to those skilled in the art, and there is no special restriction. In one embodiment, the back passivation layer preferably comprises an aluminum oxide layer, and more preferably comprises an aluminum oxide layer and a silicon nitride layer arranged in a stacked manner. A thickness of the aluminum oxide layer is preferably 2nm to 20nm. A thickness of the silicon nitride layer is preferably 60nm to 200nm.

The second electrode is provided on the back surface of the silicon substrate. That is, the second electrode is provided in the non-columnar hole region of the silicon substrate. The second electrode has a polarity opposite to that of the first electrode. The second electrode and the first electrode are insulated from each other. A shape of the second electrode is preferably cylindrical. A diameter of the second electrode is preferably 10µm to 30µm. A type of the second electrode is preferably a silver electrode. The number of the second electrodes is preferably plural. The plural second electrodes are preferably connected by a second conductive gate line, which can also be called a second conductive paste line. The first conductive gate line or the first conductive paste line is not in contact with the second conductive gate line or the second conductive paste line. Further, preferably, the second conductive gate line or the second conductive paste line is arranged on the surface of the back passivation layer to connect the plural second electrodes. Furthermore, preferably, the second conductive gate line or the second conductive paste line connects the second electrodes in a square spiral shape. Reference is made to FIG. 3, which is a schematic diagram of an electrode distribution of the back contact solar cell according to an embodiment of the present disclosure, where black dots are the first electrodes, the black line is the first conductive gate line or the first conductive paste line, red dots are the second electrodes, and the red line is the second conductive gate line or the second conductive paste line. A width of the second conductive gate line or the second conductive paste line is preferably 100µm to 2000µm. The second conductive gate line or the second conductive paste line may be any type known to those skilled in the art, without any special restriction. In one embodiment, the second conductive gate line or the second conductive paste line is preferably aluminum paste (sintered according to methods known to those skilled in the art).

A front surface of the silicon substrate is a pyramidal textured surface. The front surface of the silicon substrate is provided with a front passivation layer. The front passivation layer is provided on a light-receiving surface of the silicon substrate. A thickness of the front passivation layer is preferably 57nm to 120nm. The front passivation layer may be any front passivation layer known to those skilled in the art, without any special restrictions. In one embodiment, the front passivation layer is preferably an aluminum oxide layer. Further, the front passivation layer preferably comprises an aluminum oxide layer, a silicon nitride layer and a silicon oxide layer arranged in a stacked manner. The aluminum oxide layer has high-density fixed negative charges and is suitable for surface passivation of a p-type silicon wafer. A thickness of the aluminum oxide layer is preferably 2µm to 20µm. A thickness of the silicon nitride layer is preferably 50nm to 80nm. A thickness of the silicon oxide layer is preferably 5nm to 20nm.

In the present disclosure, the columnar hole and/or conical hole structure is utilized to arrange the back surface field region, such that the thickness of the silicon substrate can be fully utilized to form a back surface field region of the bottom region and the side walls of the holes, which increases the area of the back surface field collection region without occupying the back surface area, and also maximizes the back emission area. For a solar cell, within a certain range of proportions, the larger the proportion of the emitter area, the higher the capture and transmission performance of minority carriers. The efficiency of the cell is relatively high. The back surface field region deeply penetrates into the silicon wafer, so that majority carriers can be collected inside the silicon wafer, shortening the transmission and collection distance and enhancing the collecting effect. Therefore, the structure has an enhanced collecting effect on both minority carriers and majority carriers, thereby improving the efficiency of the cell as a whole.

The present disclosure further provides a method for manufacturing the above-mentioned back contact solar cell, comprising following steps: S1) depositing an intrinsic amorphous silicon layer on the back surface of the silicon substrate; S2) performing a first doping treatment on the silicon substrate on which the intrinsic amorphous silicon layer is deposited to form a doped polysilicon layer; S3) printing an acidic corrosive material on the back surface of the silicon substrate on which the doped polysilicon layer is formed, and performing a polishing treatment to form a columnar hole and/or conical hole; S4) performing a second doping treatment on the silicon substrate on which the columnar hole and/or conical hole are formed to form a doped back surface field layer; S5) performing pickling on the silicon substrate on which the doped back surface field layer is formed; S6) preparing a first electrode in electrical contact with the doped back surface field layer and preparing a second electrode in electrical contact with the doped polysilicon layer respectively on the back surface of the silicon substrate after pickling to obtain the back contact solar cell, where the first electrode and the second electrode have opposite polarities and are insulated from each other.

The present disclosure has no special restrictions on sources of all raw materials, which may be commercially available.

In one embodiment, the silicon substrate is preferably subjected to a double-sided polishing treatment. The double-sided polishing treatment is a method well known to those skilled in the art, and there is no special restriction. In one embodiment, alkali polishing is preferably used. An alkali in an alkaline polishing solution used for the alkali polishing is preferably one or more of potassium hydroxide, sodium hydroxide and tetramethylammonium hydroxide (TMAH). The alkali in the alkaline polishing solution has a mass concentration of preferably 5% to 20%. In addition to the alkali, a polishing additive may be added into the alkaline polishing solution, which is conducive to obtaining a flatter surface. The polishing treatment is carried out at a temperature of preferably 60°C to 90°C. The polishing treatment can remove the cutting damage on the surface and smooth the surface, thereby reducing surface defects.

Then, the intrinsic amorphous silicon layer is deposited on the back surface of the silicon substrate, and more preferably, the tunneling oxide layer is first deposited on the back surface of the silicon substrate and then the intrinsic amorphous silicon layer is deposited. In one embodiment, the tunneling oxide layer may be a silicon oxide layer, a silicon nitride oxide layer or a silicon nitride layer. The method for depositing the tunneling oxide layer may be a method well known to those skilled in the art, and there is no special restriction. In one embodiment, the method preferably uses one or more of low pressure chemical vapor deposition (LPCVD), plasma chemical vapor deposition (PECVD) and plasma enhanced atomic layer deposition (PEALD). A thickness of the tunneling oxide layer is preferably 0.1nm to 5nm. The method for depositing the intrinsic amorphous silicon layer may be a method well known to those skilled in the art. In one embodiment, the method is one or more of LPCVD, PEALD and PVD (physical vapor deposition). A thickness of the intrinsic amorphous silicon layer is preferably 30nm to 300nm.

The silicon substrate on which the intrinsic amorphous silicon layer is deposited is subjected to the first doping treatment to form the doped polysilicon layer. The method of the doping treatment is selected according to types of the silicon substrate and doping elements in the doped polysilicon layer. When the silicon substrate is a P-type silicon substrate, this method is preferably diffusion of group V elements or ion implantation of group V elements, more preferably phosphorus diffusion or ion implantation of phosphorus. The phosphorus diffusion is preferably high-temperature tubular phosphorus diffusion. A phosphorus source of the phosphorus diffusion is preferably phosphorus oxychloride. A temperature of the phosphorus diffusion is preferably 930°C to 980°C. A time of the phosphorus diffusion is preferably 60min to 80min. An energy of the ion implantation of phosphorus is preferably 5keV to 200keV. A dose of the ion implantation of phosphorus is preferably 1*10¹⁹/cm³ to 10*10¹⁹/cm³. After the ion implantation of phosphorus, an oxidation annealing treatment is preferably performed. A temperature of the oxidation annealing treatment is preferably 900°C to 980°C. A time of the oxidation annealing treatment is preferably 30min to 50min. The oxidation annealing treatment is preferably performed in an air atmosphere. After the phosphorus diffusion or ion implantation of phosphorus, a sheet resistance of the silicon substrate is preferably 20Ω/□ to 80Ω/□, more preferably 20Ω/□ to 50Ω/□. In this process, a silicon oxide layer containing phosphorus elements (commonly known as PSG layer) with a thickness of preferably 40nm to 60nm is formed on the surface. When this step is doping by phosphorus diffusion, a phosphorus-doped conventional emitter may be formed on the front surface, which plays a role in absorbing impurities. In the subsequent texturing step, the emitter and the absorbed impurities may be removed together. In this step, the intrinsic amorphous silicon will be transformed into the corresponding doped polysilicon. When the silicon substrate is an N-type silicon substrate, the first doping treatment is preferably doping with group III elements, more preferably boron diffusion. The boron diffusion is preferably a high-temperature tubular boron diffusion treatment. A boron source of the boron diffusion is preferably boron trichloride and/or boron tribromide. A temperature of the boron diffusion is preferably 930°C to 980°C. A time of the boron diffusion is preferably 60min to 80min. A sheet resistance of the silicon substrate after the boron diffusion treatment is preferably 20Ω/□ to 80Ω/□, more preferably 40Ω/□ to 50Ω/□. In this process, a silicon oxide layer containing boron elements (commonly known as a BSG layer) with a thickness of preferably 40nm to 60nm is formed on the surface.

The acidic corrosive material is printed on the back surface of the silicon substrate on which the doped polysilicon layer is formed. In one embodiment, the acidic corrosive material is printed according to the distribution of columnar holes and/or conical holes through screen printing. The acidic corrosive material may remove the PSG or BSG formed in the first doping treatment to expose the underlying silicon substrate. The acidic corrosive material preferably comprises oxalic acid, surfactant, thickener, modified silicon dioxide, deionized water and sodium fluoride, which can corrode the PSG layer or BSG layer at room temperature or under heating conditions. The oxalic acid in the acidic corrosive material has a mass concentration of preferably 5% to 20%. The surfactant in the acidic corrosive material has a mass concentration of preferably 5% to 10%. The type of surfactant is preferably sodium citrate. The thickener in the acidic corrosive material has a mass concentration of preferably 10% to 20%. The type of the thickener is preferably resin. The modified silicon dioxide in the acidic corrosive material has a mass concentration of preferably 20% to 40%. The modified silicon dioxide is preferably silicon dioxide particles with a smooth surface treatment and a diameter of 10µm to 20µm. The deionized water in the acidic corrosive material has a mass concentration of preferably 5% to 20%. The sodium fluoride in the acidic corrosive material has a mass concentration of preferably 1% to 10%. After printing the acidic corrosive material, the residual corrosive material is cleaned and removed, and the PSG layer or BSG layer on the back surface without being printed with the acidic corrosive material is still retained, which may be used as an alkali barrier layer to protect the underlying doped polysilicon layer during the polishing process. The PSG layer or BSG layer, as a byproduct of the first doping treatment, can play a role in blocking alkali etching. There is no need to deposit a silicon oxide layer or a silicon nitride layer separately as a barrier layer for alkali etching, which reduces process steps and costs.

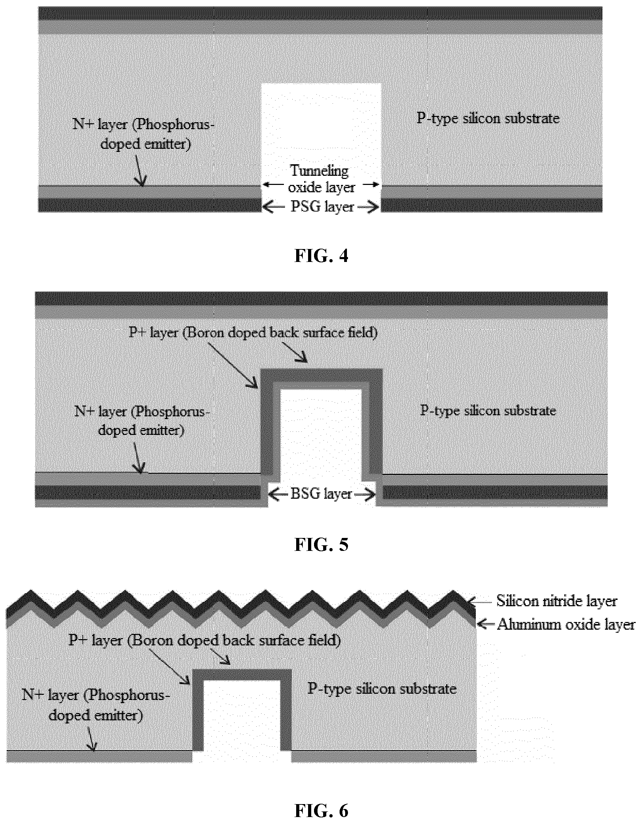

The silicon substrate from which the acidic corrosive material has been cleaned is subjected to a polishing treatment to form a columnar hole and/or a conical hole. The method of the polishing treatment is a method well known to those skilled in the art and is not particularly restricted. In one embodiment, the alkali polishing is preferably used. The alkali in the alkaline polishing solution used for the alkali polishing is preferably one or more of potassium hydroxide, sodium hydroxide and tetramethylammonium hydroxide (TMAH). The alkali in the alkaline polishing solution has a mass concentration of preferably 5% to 20%. In addition to the alkali, a polishing additive may be added into the alkaline polishing solution, which has a function of protecting the oxide layer to ensure that the PSG layer or the BSG layer will not be corroded. In one embodiment, the PSG layer or the BSG layer has a remaining of 30nm to 50nm. The polishing treatment is carried out at a temperature of preferably 60°C to 90°C. The region not covered and protected by the PSG layer or the BSG layer forms a polished flat structure. That is, a polished structure appears in a pattern region on the back surface, and the polished structure has a certain depth, forming a columnar hole and/or a conical hole. The depth of the columnar hole and/or conical hole is preferably 30% to 80% of the thickness of the silicon wafer. In this step, as the front surface of the silicon substrate is protected by the PSG layer or the BSG layer, it is not polished. Reference is made to FIG. 4, which is a schematic structural diagram of a P-type silicon substrate after being corroded and polished to form a columnar hole.

The silicon substrate on which the columnar hole and/or conical hole are formed is subjected to a second doping treatment to form the doped back surface field layer. The method of the second doping treatment may be selected according to types of silicon substrate and the doping elements in the doped polysilicon layer. When the silicon substrate is a P-type silicon substrate, this step is preferably doping with group III elements, more preferably boron diffusion. The method of boron diffusion is the same as described above and will not be repeated here. When the silicon substrate is an N-type silicon substrate, this step is preferably diffusion of group V elements or ion implantation of group V elements, more preferably phosphorus diffusion or ion implantation of phosphorus. The methods of phosphorus diffusion and ion implantation of phosphorus are the same as described above and will not be repeated here. Reference is made to FIG. 5, which is a schematic structural diagram of a P-type silicon substrate after the second doping treatment to form a doped back surface field layer.

The PSG layer or the BSG layer will be formed on the front surface of the silicon substrate during the first doping treatment, thus it is preferred to remove the PSG layer or the BSG layer on the front surface of the silicon substrate on which the doped back surface field layer is formed. Then a texturing treatment is performed, and then a pickling treatment is performed to remove the PSG layer and the BSG layer on the back surface of the silicon substrate. The PSG layer or the BSG layer on the front surface is preferably removed by an inline etch machine. A solution used in the inline etch machine is preferably a hydrofluoric acid solution, more preferably a 1% to 10% hydrofluoric acid solution. A solution used in the texturing treatment is preferably an alkaline solution. The alkali in the solution used in the texturing treatment is preferably one or more of potassium hydroxide, sodium hydroxide and tetramethylammonium hydroxide (TMAH). The alkali in the solution used in the texturing treatment has a mass concentration of preferably 5% to 20%. During the texturing treatment, it is preferred to add a texturing additive. The additive is preferably an additive with a function of protecting the oxide layer. The front surface of the silicon substrate is made to a pyramid textured surface through the texturing treatment, which plays a role in light trapping. The back surface is protected by an oxide layer so that texturing phenomenon does not occur. After the front surface is textured, the BGS layer and PSG layer on the back surface are removed by pickling. A solution used in the pickling is preferably a hydrofluoric acid solution, and more preferably a hydrofluoric acid solution with a concentration of 1% to 10%. Reference is made to FIG. 6, which is a schematic structural diagram of the silicon substrate after pickling.

According to the present disclosure, a back passivation layer is preferably deposited on the back surface of the silicon substrate after pickling. Further, a front passivation layer is preferably deposited on the front surface of the silicon substrate after pickling. In one embodiment, there are no special restrictions on the order of depositing the front passivation layer and the back passivation layer. The front passivation layer may be deposited first or the back passivation layer may be deposited first, without special restrictions. In one embodiment, in order to save preparation steps, the front passivation layer and the back passivation layer are preferably prepared at the same time, and more preferably prepared in a same reaction chamber. The types of the front passivation layer and the back passivation layer are the same as described above, and will not be repeated here. In one embodiment, further, the front passivation layer and the back passivation layer are preferably prepared on the silicon substrate after pickling through coating double-sided aluminum oxide. The method for depositing the front passivation layer and the back passivation layer is a method well known to those skilled in the art, and there is no special restriction. In one embodiment, PECVD, ALD or PEALD is preferred.

A first electrode in electrical contact with the doped back surface field layer and a second electrode in electrical contact with the doped polysilicon layer are respectively prepared on the back surface of the silicon substrate on which the back passivation layer is deposited. That is, a first electrode is prepared in the columnar hole and/or conical hole on the back surface of the silicon substrate on which the back passivation layer is deposited, and a second electrode is prepared in the non-columnar hole region, so as to obtain a back contact solar cell. The first electrode is preferably prepared according to the following process: forming an opening in the columnar hole and/or conical hole through using a laser or an acid etching material, removing the back passivation layer in a region of the opening, and printing the first electrode. In one embodiment, a first conductive paste is preferably printed at the same time to form a first conductive paste line to connect the first electrode. A diameter of the opening is preferably 10µm to 50µm. The first electrode is preferably low-corrosive aluminum paste or non-corrosive aluminum. The first conductive paste is preferably low-corrosive aluminum paste or non-corrosive aluminum paste. The second electrode is preferably prepared according to the following process: printing a corrosive paste in the non-columnar hole region to form the second electrode, and then printing a second conductive paste to form a second conductive paste line to connect the second electrode. The corrosive paste is preferably corrosive silver paste. The glass frit in the corrosive paste may open the back passivation layer so that the paste contacts the doped polysilicon layer. The second conductive paste is preferably low-corrosive aluminum paste or non-corrosive aluminum paste. Finally, electrical contact is preferably formed by sintering, to obtain a back contact solar cell. The sintering is carried out at a temperature of preferably 600°C to 800°C; and the sintering is carried out for a time of preferably 2min to 5min.

In order to further illustrate the present disclosure, the back contact solar cell and the method for manufacturing thereof provided by the present disclosure are described in detail in combination with embodiments below.

The reagents used in the following embodiments are all commercially available. The polishing additive used in the embodiments: Shaoxing Topone New Energy Co., Ltd., polishing additive, model PI10V02. The resin thickener used in the embodiments: Xiamen Hower New Materials Co., Ltd., model HR575. The silica particles with smooth surface treatment are: Xiamen Hower New Materials Co., Ltd., model HR575. The texturing additive: Shaoxing Topone New Energy Co., Ltd., model EP32.

### Example 1

### 1.1: Double-sided polishing of P-type silicon wafer

Conventional alkaline polishing was performed by using 10% potassium hydroxide solution and 1% polishing additive for a chemical reaction at 80°C for 300s, with the purpose of removing the cutting damage on the surface, smoothing the surface and reducing surface defects.

### 1.2: Deposition of tunneling layer and intrinsic amorphous silicon layer on the back surface

The silicon oxide layer as the tunneling layer was deposited on the back surface with a thickness of 1.5nm through using low pressure chemical vapor deposition (LPCVD), and then the intrinsic amorphous silicon was deposited with a thickness of 150nm through using the LPCVD.

### 1.3: Double-sided phosphorus diffusion

The silicon wafer obtained in step 1.2 was subjected to the double-sided phosphorus diffusion. The specific process was high-temperature tubular phosphorus diffusion. The phosphorus source was phosphorus oxychloride (POCl₃). The phosphorus diffusion was carried out at a temperature of 950°C for 60min. Then an oxidation annealing was performed at 900°C in air atmosphere for 30 min. The sheet resistance of the silicon wafer after phosphorus diffusion is 50Ω/□. In this process, a silicon oxide layer containing phosphorus elements (commonly known as the PSG layer) with a thickness of 40nm was formed on the surface.

At this time, double-sided phosphorus diffusion was carried out. A phosphorus-doped conventional emitter would be formed on the front surface, which played a role in absorbing impurities. In the subsequent texturing step, the emitter and the absorbed impurities would be removed together. In this step, the intrinsic amorphous silicon would be converted into the corresponding N-type doped polysilicon.

### 1.4: Printing acidic corrosive material

After the double-sided phosphorus diffusion, the PSG layer, i.e. a phosphorus-containing silicon dioxide layer, would be formed on the front surface and back surface of the silicon wafer. At this time, the acidic corrosive material was printed by screen printing according to the pattern of the cylindrical hole-shaped back surface field region. The cylindrical hole-shaped back surface field region had a diameter of 100µm. The cylinder spacing was 1000µm. The corrosive material may corrode and remove the PSG layer at this position, thereby exposing the underlying P-type silicon substrate.

The corrosive material was composed of oxalic acid, surfactant, thickener, modified silicon dioxide, deionized water, and sodium fluoride, and had a corrosive effect on the PSG layer at room temperature or under heating condition. The content of each component was: oxalic acid 10 wt%, surfactant sodium citrate 8 wt%, thickener resin 10 wt%, silicon dioxide particles with smooth surface treatment 30 wt%, sodium fluoride 5 wt% and the remaining of deionized water. After printing the corrosive material, the residual corrosive material was removed by cleaning. The PSG layer on the back surface without being printed with the acidic corrosive material was still retained as an alkali barrier layer during the polishing process in S5 to protect the underlying N-type doped polysilicon. (The PSG layer, as a byproduct in the phosphorus diffusion process, played a role in blocking alkali etching. There was no need to deposit a silicon oxide layer or a silicon nitride layer separately as a barrier layer for alkali etching, which reduced process steps and costs).

### 1.5: Polishing the cylindrical hole-shaped region on the back surface to form a hole

The silicon wafer from which the acidic corrosive material had been cleaned was subjected to the polishing treatment. That is, the polishing treatment was carried out under the action of 10% potassium hydroxide and 1% polishing additive. The additive had a function of protecting the oxide layer. The polishing treatment was carried out at 80°C for 300s. It was ensured that the PSG was not corroded too much and the remained PSG was 30 nm. A polished flat structure was formed in the region not covered and protected by the PSG layer. That is, the polished structure appeared in the pattern region on the back surface, and the polished structure had a certain depth. The depth of the cylindrical hole was 50% of the thickness of the silicon wafer. The front surface of the silicon wafer was protected by the PSG layer and was not polished.

### 1.6: Boron diffusion on the back surface

The silicon wafer obtained in step 1.5 was subjected to boron diffusion on the back surface. The specific process was high-temperature tubular boron diffusion. The boron source was boron trichloride (BCl₃). The boron diffusion was carried out at a temperature of 950°C for 60 min. The sheet resistance of the silicon wafer after boron diffusion was 40Ω/□. In this process, a silicon oxide layer containing boron elements (commonly known as the BSG layer) with a thickness of 50nm was formed on the surface.

### 1.7: Removal of the PSG layer on the front surface and texturing treatment on the front surface

The silicon wafer obtained in 1.6 was subjected to removal of the PSG layer on the front surface using a HF solution of a concentration of 5% in an inline etch machine. Then the texturing treatment was carried out in a 10% potassium hydroxide solution with a 1.5% texturing additive. The texturing additive had a function of protecting the oxide layer. The texturing treatment was carried out at a temperature of 80°C for 400s. That is, the entire front surface was a pyramid textured surface, which played a role of light trapping. The back surface was protected by an oxide layer, so that texturing phenomenon did not occur. After the front surface was textured, the BGS layer and PSG layer on the back surface were removed by pickling using an HF solution with a concentration of 50% for 300s.

### 1.8: Stacked passivation films on the front surface and the back surface

The front surface and back surface were deposited with a hydrogen-containing dielectric layer, which played a role in chemically passivating the back surface. Specifically, the back surface has stacked passivation films of aluminum oxide and silicon nitride. The aluminum oxide was prepared by PECVD with a thickness of 10nm. The silicon nitride was prepared by PECVD with a thickness of 100nm. The front surface had a stacking film of aluminum oxide, silicon nitride and silicon oxide, which were all prepared by PECVD with thicknesses of 10nm, 50nm, and 5nm respectively.

### 1.9: Metallization on the back surface (distribution structure as shown in FIG. 3)

Laser or acid etching material was used to open the cylindrical deep hole in the P region to form an opening. A diameter of the opening was 50µm. Only the dielectric layer was removed from the opening region. A low-corrosive aluminum paste (black dots) was printed above the opening region of the P region with a shape of cylindrical and a diameter of 50µm. Its height extended to near the back surface of the silicon wafer, which played a role of electrically contacting with the P region. At the same time, black low-corrosive aluminum paste was printed at a width of 20Ωµm, to connect the black contact points of the P region.

Corrosive silver paste was printed on a part of the N-type polysilicon (the red dots were firing-through paste contact points of the emitter, and had a diameter of 20µm). The glass frit in the corrosive silver paste may open the dielectric layer, so that the silver contacted the N-type polysilicon. Then non-corrosive connecting lines (red line segments) were printed to connect the red contact points, and the non-corrosive connecting lines had a width of 100µm. Finally, co-sintering was performed at 800°C for 3min to form electrodes.

### Example 2

### 2.1: Double-sided polishing of P-type silicon wafer

Conventional alkaline polishing was performed by using 20% potassium hydroxide solution and 1.5% polishing additive for a chemical reaction at 80°C for 300s, with the purpose of removing the cutting damage on the surface, smoothing the surface and reducing surface defects.

### 2.2: Deposition of tunneling layer and intrinsic amorphous silicon layer on the back surface

The silicon oxide layer as the tunneling layer was deposited on the back surface with a thickness of 2nm through using low pressure chemical vapor deposition (LPCVD), and then the intrinsic amorphous silicon was deposited with a thickness of 250nm through using the LPCVD.

### 2.3: Double-sided phosphorus diffusion

The silicon wafer obtained in step 2.2 was subjected to the double-sided phosphorus diffusion. The specific process was high-temperature tubular phosphorus diffusion. The phosphorus source was phosphorus oxychloride (POCl₃). The phosphorus diffusion was carried out at a temperature of 935°C for 60min. Then an oxidation annealing was performed at 900°C in air atmosphere for 30 min. The sheet resistance of the silicon wafer after phosphorus diffusion is 20Ω/□. In this process, a silicon oxide layer containing phosphorus elements (commonly known as the PSG layer) with a thickness of 40nm was formed on the surface.

At this time, double-sided phosphorus diffusion was carried out. A phosphorus-doped conventional emitter would be formed on the front surface, which played a role in absorbing impurities. In the subsequent texturing step, the emitter and the absorbed impurities would be removed together. In this step, the intrinsic amorphous silicon would be converted into the corresponding N-type doped polysilicon.

### 2.4: Printing acidic corrosive material

After the double-sided phosphorus diffusion, the PSG layer, i.e. a phosphorus-containing silicon dioxide layer, would be formed on the front surface and back surface of the silicon wafer. At this time, the acidic corrosive material was printed by screen printing according to the pattern of the cylindrical hole-shaped back surface field region. The cylindrical hole-shaped back surface field region had a diameter of 100µm. The cylinder spacing was 1000µm. The corrosive material may corrode and remove the PSG layer at this position, thereby exposing the underlying P-type silicon substrate.

The corrosive material was composed of oxalic acid, surfactant, thickener, modified silicon dioxide, deionized water, and sodium fluoride, and had a corrosive effect on the PSG layer at room temperature or under heating condition. The content of each component was: oxalic acid 10 wt%, surfactant sodium citrate 8 wt%, thickener resin 10 wt%, silicon dioxide particles with smooth surface treatment 30 wt%, sodium fluoride 5 wt% and the remaining of deionized water. After printing the corrosive material, the residual corrosive material was removed by cleaning. The PSG layer on the back surface without being printed with the acidic corrosive material was still retained as an alkali barrier layer during the polishing process in 2.5 to protect the underlying N-type doped polysilicon. (The PSG layer, as a byproduct in the phosphorus diffusion process, played a role in blocking alkali etching. There was no need to deposit a silicon oxide layer or a silicon nitride layer separately as a barrier layer for alkali etching, which reduced process steps and costs).

### 2.5: Polishing the cylindrical hole-shaped region on the back surface to form a hole

The silicon wafer from which the acidic corrosive material had been cleaned was subjected to the polishing treatment. That is, the polishing treatment was carried out under the action of 15% potassium hydroxide and 1.2% polishing additive. The additive had a function of protecting the oxide layer. The polishing treatment was carried out at 80°C for 300s. It was ensured that the PSG was not corroded too much and the remained PSG was 30 nm. A polished flat structure was formed in the region not covered and protected by the PSG layer. That is, the polished structure appeared in the pattern region on the back surface, and the polished structure had a certain depth. The depth of the cylindrical hole was 40% of the thickness of the silicon wafer. The front surface of the silicon wafer was protected by the PSG layer and was not polished.

### 2.6: Boron diffusion on the back surface

The silicon wafer obtained in step 2.5 was subjected to boron diffusion on the back surface. The specific process was high-temperature tubular boron diffusion. The boron source was boron trichloride (BCl₃). The boron diffusion was carried out at a temperature of 950°C for 60 min. The sheet resistance of the silicon wafer after boron diffusion was 40Ω/□. In this process, a silicon oxide layer containing boron elements (commonly known as the BSG layer) with a thickness of 40nm to 50nm was formed on the surface.

### 2.7: Removal of the PSG layer on the front surface and texturing treatment on the front surface

The silicon wafer obtained in 2.6 was subjected to removal of the PSG layer on the front surface using a HF solution of a concentration of 5% in an inline etch machine. Then the texturing treatment was carried out in a 10% potassium hydroxide solution with a 1.5% texturing additive. The texturing additive had a function of protecting the oxide layer. The texturing treatment was carried out at a temperature of 80°C for 400s. That is, the entire front surface was a pyramid textured surface, which played a role of light trapping. The back surface was protected by an oxide layer, so that texturing phenomenon did not occur. After the front surface was textured, the BGS layer and PSG layer on the back surface were removed by pickling using an HF solution with a concentration of 50% for 300s.

### 2.8: Stacked passivation films on the front surface and the back surface

The front surface and back surface were deposited with a hydrogen-containing dielectric layer, which played a role in chemically passivating the back surface. Specifically, the back surface has stacked passivation films of aluminum oxide and silicon nitride. The aluminum oxide was prepared by PECVD with a thickness of 10nm. The silicon nitride was prepared by PECVD with a thickness of 100nm. The front surface had a stacking film of aluminum oxide, silicon nitride and silicon oxide, which were all prepared by PECVD with thicknesses of 10nm, 50nm, and 5nm respectively.

### 2.9: Metallization on the back surface (distribution structure as shown in FIG. 3)

Laser or acid etching material was used to open the cylindrical deep hole in the P region to form an opening. A diameter of the opening was 50µm. Only the dielectric layer was removed from the opening region. A low-corrosive aluminum paste (black dots) was printed above the opening region of the P region with a shape of cylindrical and a diameter of 50µm. Its height extended to near the back surface of the silicon wafer, which played a role of electrically contacting with the P region. At the same time, black low-corrosive aluminum paste was printed at a width of 50µm to connect the black contact points of the P region.

Corrosive silver paste was printed on a part of the N-type polysilicon (the red dots were firing-through paste contact points of the emitter, and had a diameter of 20µm). The glass frit in the corrosive silver paste may open the dielectric layer, so that the silver contacted the N-type polysilicon. Then non-corrosive connecting lines (red line segments) were printed to connect the red contact points, and the non-corrosive connecting lines had a width of 100µm. Finally, co-sintering was performed at 780°C for 3min to form electrodes.

The back contact solar cells obtained in Example 1 and Example 2 were tested for performance. The testing method was a battery electrical performance test under STC standard conditions (25°C, 1000W/m², AM1.5G light source). The results are shown in Table 1. The conventional IBC cells in Table 1 are "Zebra" IBC cells produced by State Power Investment Xining Solar Power Co., Ltd., with a size of 166*166mm, and the specific model is the "Andromeda" series.

**Table 1 Solar cell performance test results**

| Cell types | Short circuit current density | Open circuit voltage | Fill Factor | Conversion efficiency |
|---|---|---|---|---|
| Conventional IBC cell | 41.7 mA/cm² | 705 mv | 82% | 24.22% |
| Example 1 | 42 mA/cm² | 720 mv | 82.3% | 24.88% |
| Example 2 | 42 .1mA/cm² | 725 mv | 82.5% | 25.18% |

The specific embodiments described herein are merely examples of the spirit of the present disclosure. Those skilled in the art may make various modifications or additions to the specific embodiments described or replace them in similar ways, but they will not deviate from the spirit of the present disclosure or exceed the scope defined by the appended claims.

## Claims

1. A back contact solar cell, wherein the back contact solar cell comprises:
a silicon substrate,
wherein a back surface of the silicon substrate is provided with a columnar hole and a non-columnar hole region;
a doped back surface field layer provided in the columnar hole;
a first electrode provided on the back surface of the silicon substrate, wherein the first electrode is in electrical contact with the doped back surface field layer;
a doped emitter layer provided in the non-columnar hole region, wherein the doped emitter layer comprises a doped polysilicon layer; and
a second electrode provided on the back surface of the silicon substrate, wherein the second electrode is in electrical contact with the doped polysilicon layer;
wherein the first electrode and the second electrode have opposite polarities and are insulated from each other.

2. A back contact solar cell, wherein the back contact solar cell comprises:
a silicon substrate, wherein the silicon substrate has a first doping type;
wherein a back surface of the silicon substrate is provided with a columnar hole and/or a conical hole and a non-columnar hole region;
a doped back surface field layer provided in the columnar hole, wherein the back surface field layer has the first doping type;
a first electrode provided on the back surface of the silicon substrate, wherein the first electrode is in electrical contact with the doped back surface field layer;
a doped emitter layer provided in the non-columnar hole region, wherein the doped emitter layer comprises a doped polysilicon layer, and the doped polysilicon layer has a second doping type ; and
a second electrode provided on the back surface of the silicon substrate, wherein the second electrode is in electrical contact with the doped polysilicon layer;
wherein the first electrode and the second electrode have opposite polarities and are insulated from each other.

3. The back contact solar cell according to claim 1 or 2, wherein the doped back surface field layer is provided on a side wall or a bottom surface of the columnar hole and/or conical hole.

4. The back contact solar cell according to claim 1 or 2, wherein a diameter of the columnar hole and/or conical hole is 50-300 µm, the number of the columnar hole and/or conical hole is plural, an interval between adjacent columnar holes and/or conical holes is 500-3000 µm, a depth of the columnar hole and/or conical hole is 30%-80% of a thickness of the silicon substrate.

5. The back contact solar cell according to claim 1 or 2, wherein the number of the columnar hole and/or conical hole is plural, the first electrode is provide in each columnar hole and/or conical hole, the plural first electrodes are connected through a first conductive gate line;
a number of the second electrode is plural, the plural second electrodes are connected through a second conductive gate line;
the first conductive gate line is not in contact with the second conductive gate line.

6. The back contact solar cell according to claim 5, wherein the first conductive gate line connects the first electrodes in a square spiral shape,
the second conductive gate line connects the second electrodes in a square spiral shape.

7. The back contact solar cell according to claim 1 or 2, wherein the doped emitter layer further comprises a tunneling oxide layer, and the tunneling oxide layer is provided between the silicon substrate and the doped polysilicon layer in the non-columnar hole region.

8. The back contact solar cell according to claim 7, wherein a thickness of the tunneling oxide layer is 0.1nm to 5nm, a thickness of the doped polysilicon layer is 30nm to 300nm, a diameter of the first electrode is 200µm to 100µm, a diameter of the second electrode is 10µm to 30µm.

9. The back contact solar cell according to claim 1 or 2, wherein the silicon substrate is a P-type silicon substrate, the doped back surface field layer is a back surface field layer doped with group III elements, the doped polysilicon layer is a polysilicon layer doped with group V elements.

10. The back contact solar cell according to claim 8, further comprising a front passivation layer and a back passivation layer, wherein the front passivation layer is provided on a light-receiving surface of the silicon substrate, the back passivation layer is provided on the back surface of the silicon substrate and covers the doped back surface field layer and the doped polysilicon layer, the front passivation layer and the back passivation layer comprise aluminum oxide, the back passivation layer is provided with an opening, the first electrode is in electrical contact with the doped back surface field layer through the opening, the second electrode is in electrical contact with the doped polysilicon layer through the opening.

11. The back contact solar cell according to claim 1 or 2, wherein a bottom and/or a side wall of the columnar hole and/or conical hole is provided with a concave-convex texture structure.

12. A method for manufacturing a back contact solar cell, comprising following steps:
S1) depositing an intrinsic amorphous silicon layer on a back surface of a silicon substrate;
S2) performing a first doping treatment on the silicon substrate on which the intrinsic amorphous silicon layer is deposited to form a doped polysilicon layer;
S3) printing an acidic corrosive material on the back surface of the silicon substrate on which the doped polysilicon layer is formed, and performing a polishing treatment to form a columnar hole and/or a conical hole;
S4) performing a second doping treatment on the silicon substrate on which the columnar hole and/or conical hole are formed to form a doped back surface field layer;
S5) performing pickling on the silicon substrate on which the doped back surface field layer is formed; and
S6) preparing a first electrode in electrical contact with the doped back surface field layer and preparing a second electrode in electrical contact with the doped polysilicon layer respectively on the back surface of the silicon substrate after pickling to obtain the back contact solar cell, wherein the first electrode and the second electrode have opposite polarities and are insulated from each other.

13. The method according to claim 12, wherein in step S2), the first doping treatment is double-sided diffusion doping, and after step S4), the method further comprises a texturing treatment on a front surface of the silicon substrate to remove a doping layer formed on the front surface of the silicon substrate during the first doping treatment.

14. The method according to claim 12, wherein in step S3), the acidic corrosive material comprises oxalic acid, surfactant, thickener, modified silicon dioxide, deionized water and sodium fluoride, the oxalic acid in the acidic corrosive material has a mass concentration of 5% to 20%, the surfactant in the acidic corrosive material has a mass concentration of 5% to 10%, the thickener in the acidic corrosive material has a mass concentration of 10% to 20%, the modified silicon dioxide in the acidic corrosive material has a mass concentration of 20% to 40%, the deionized water in the acidic corrosive material has a mass concentration of 5% to 20%; the sodium fluoride in the acidic corrosive material has a mass concentration of 1% to 10%.

15. The method according to claim 12, wherein after the pickling of step S5), the method further comprises depositing a back passivation layer on the back surface of the silicon substrate and depositing a front passivation layer on a front surface of the silicon substrate, wherein the back passivation layer and the front passivation layer are prepared in the same reaction chamber.

16. The method according to claim 15, wherein the back passivation layer and the front passivation layer are prepared by coating aluminum oxide on both sides of the silicon substrate after pickling.

17. The method according to claim 12, wherein in step S6), the first electrode is prepared according to the following methods: forming an opening in the columnar hole and/or conical hole by using a laser or an acid etching material, removing a back passivation layer in a region of the opening and printing the first electrode.

18. The method according to claim 17, wherein when the first electrode is printed, a first conductive paste is printed to form a first conductive paste line to connect the first electrode, the first electrode is a low-corrosive aluminum paste or a non-corrosive aluminum, the first conductive paste is a low-corrosive aluminum paste or a non-corrosive aluminum paste.

19. The method according to claim 12, wherein the second electrode is prepared specifically as follows: printing a corrosive paste in the non-columnar hole region to form the second electrode, then printing a second conductive paste to form a second conductive paste line to connect the second electrode, wherein the corrosive paste is a corrosive silver paste, the second conductive paste is a low-corrosive aluminum paste or a non-corrosive aluminum paste.

20. The method according to claim 12, wherein the preparing the first electrode in electrical contact with the doped back surface field layer and preparing the second electrode in electrical contact with the doped polysilicon layer respectively on the back surface of the silicon substrate after pickling comprises sintering to form an electrical contact, the sintering is carried out at a temperature of 600°C to 800°C, and the sintering is carried out for a time of 2min to 5min.
